# EUROPEAN PATENT APPLICATION

(11) **EP 4 775 342 A2**
(43) Date of publication of application: **15.07.2026**
(21) Application number: 25224243.3
(22) Date of filing: 17.12.2025
(51) Int. Cl.: B23K 1/008, B23K 1/20, H05H 1/24, H10W 72/00

(54) **APPARATUS AND PROCESS FOR REMOVAL OF SURFACE OXIDES**

(30) Priority: 17.12.2024 US 202418983946
(71) Applicant: Air Products and Chemicals, Inc., Allentown, PA 18106 (US)
(72) Inventor: ARSLANIAN, Gregory Khosrov, Pipersville, 18947 (US); WALCK, Michael Scott, Coopersburg, 18036 (US); WU, Liang, Shanghai, 201203 (CN)
(74) Representative: Kador & Partner Part mbB

(57) **Abstract**

An apparatus and process for removal of surface oxides includes an electron emitter device for emission of electrons for electron attachment to facilitate removal of oxides from solder bumps and/or solder caps on pillars of the surface of wafer(s) passing through an oven or furnace. The electron emitter device can include one or more modules having an electron emitting member with a plurality of projections positioned between different housing elements so that the projections extend through openings defined at an interface between the housing elements. Each module of the device can be releasably attached to a module support member for repair or replacement in a modular fashion via use of fasteners or other mechanism(s) (e.g. via bolts or screws, etc.) so that maintenance work can occur more quickly and efficiently to reduce downtime of equipment and improve operational flexibility.

## Description

### FIELD OF THE INVENTION

The present innovation relates to apparatuses and processes for the removal of surface oxides from the surface of a material. Some embodiments can be utilized to remove oxides on solder bumps and solder cap pillars to allow for reflow of solder bumps to provide smooth surfaces for wafers or other materials.

### BACKGROUND OF THE INVENTION

Electronic device packaging can include wafer bumped chips and corresponding integrated circuit packages that allow for interconnection. In wafer bumping, electroplated solder bumps or solder caps on electrodeposited copper pillars can be formed over a silicon wafer on which integrated circuits can be built. The wafer can then undergo solder reflow at a temperature above the solder's melting point to convert those bumps or solder caps to a ball, or spherical, shape. The formed bumps can function as electrical, mechanical, and mounting connections.

It is typically desired to remove oxides from these formed bumps and prevent additional oxidation on the surfaces of the bumps. Often, the oxide layer is removed by coating a wafer with the bumps formed thereon with flux material and subsequently exposing the coated wafer to a nitrogen gas environment to remove the oxides. This approach, however, can result in contamination of the wafer via residues and/or volatiles that may be formed. Also, use of flux material can require relatively frequent cleaning of the reflow furnace or oven that can contribute to significant operational downtime and higher maintenance costs for removal of these contaminants from the wafer processing equipment.

The use of a flux material can also affect the quality of the formed wafer. For example, in reflow processing that may occur after removing oxides with flux material, the flux can affect the molten solder and create voids inside the formed bumps that can degrade properties of the bumps.

Fluxless soldering has been performed to avoid using flux material for removing oxides from the formed bumps. Flux-free technologies often use a formic acid vapor environment. This can result in processing complications, as formic acid vapor requires utilization of a sealed vacuum system. Also, the formic acid vapor is not completely residue free, so it may contribute to wafer contamination.

Some types of fluxless technology applications include, for example, the use of lasers to ablate or heat metal oxides to their vaporization temperatures. Such processes are typically performed under inert or reducing atmospheres to prevent re-oxidation by the released contaminants. However, the melting or boiling points of the oxide and base metal can be similar, and it may not be desirable to melt or vaporize the base metal. Therefore, such laser processes are often difficult to implement. Lasers are also typically expensive and inefficient to operate and require a direct line of sight to the oxide layer, which further limits the usefulness of laser techniques for most soldering applications.

Examples of fluxless techniques for soldering and/or oxide removal can be found in U.S. Patent No. 9,053,894, 9,006,975, 8,617,352, 8,593,778, 8,454,850, 8,119,016, and 7,897,029, and U.S. Pat. App. Pub. No. 2009/0008426.

### SUMMARY OF THE INVENTION

As noted above, soldering can result in the formation of surfaces that need to be smoothed or processed to remove metal oxides. Such oxide removal can, for example, be performed to help remove metal oxides from solder bumps and/or solder caps on pillars on a wafer surface. Such processing may be performed on one or more silicon wafers having an outer surface with a plurality of bumps and/or pillars and surface oxides thereon.

One type of fluxless metal oxide removal technique can involve the dissociation of hydrogen molecules and attachment of electrons into hydrogen anions via low energy electron emissions. The conversion of metal oxides to oxide free metal surfaces is achieved when the hydrogen anions revert to their stable state. The release of energy allows for the metal oxide to be reduced to form metal.

Electron emission modules can provide an electron attachment (EA) approach for fluxless soldering that may occur at ambient pressure and normal soldering temperatures. Embodiments can be utilized in a non-flammable furnace atmosphere that includes mixtures of nitrogen gas and hydrogen gas comprising less than or equal to 5 volume percent hydrogen gas and greater than or equal to 95 volume percent nitrogen gas. In some embodiments, the atmosphere may only include nitrogen gas and hydrogen gas, in which the atmosphere comprises from 0 to 5 vol% hydrogen gas and the remainder of the atmosphere is nitrogen gas (e.g. from 95 to 100 vol%). Electron emission modules can be positioned to emit electrons toward wafers passing through a chamber or oven having this type of atmosphere so that electrons can remove oxygen from surfaces having the oxides and react with hydrogen in the atmosphere so that the oxide is removed from the wafer and a non-toxic material (e.g. water vapor) is formed in the atmosphere that may not impede the ongoing oxide removal process.

Electron emission modules can be difficult to fabricate. Often, an electron emission module includes its own anode and cathode. By applying a positive and negative pulsed direct current (DC) voltage in a range of 2 KV to 3 kV, electrons can be emitted out of the module independently toward a wafer having solder bumps and/or solder cap pillars (e.g. solder cap copper pillars) that may need to have oxides removed therefrom. When solder bumps and solder cap pillars on the wafer are isolated with ground and not able to drain charges, the emission module can collect free electrons that accumulate on the solder bumps and solder cap pillars on the wafer surface and still emit electrons via the pulsed voltage as well.

Embodiments of the electron emission module can be included on a common mounting substrate for being positioned or mounted into an oven so that an array that includes multiple different modules can be included within or on a mounting substrate. This type of design can provide improved flexibility in the fabrication of modules and in the repair or replacement of modules. In some embodiments, the formed array can be considered an electron emitter device.

For example, in the event that one or more electron emitting tips of a module need to be repaired or replaced, the array can be more easily accessed by an operator to quickly remove or repair the affected elements. This can help reduce downtime and maintenance costs while also providing improved operational flexibility.

In some embodiments, an electron emission module can include an outer housing that includes a first housing element and a second housing element. An electron emitting member having a plurality of electron emitting projections can be positioned in chambers of these housing elements and positioned between the housing elements so that the distal ends of the projections extend from openings defined between the first and second housing elements. One or more fasteners (e.g. screws and/or bolts) can be utilized to join or attach the first and second housing elements together to position the electron emission member between those elements so that the body of the member is enclosed by those elements and the distal ends of the projections of the electron emitting member extend out of the housing elements and are beyond an external outer surface of the housing elements.

The substrate to which the electron emission modules are attachable can include multiple members. A module support member can include a pre-selected arrangement of openings and wiring conduit channels defined therein for facilitating the routing of wiring to the modules so that a DC current can be pulsed to the electron emitting members of the modules attached to the module support member. In some embodiments, a second mounting member can be attached to the module support member to facilitate the mounting of the array of electron emission modules. In other embodiments, the module support member can also facilitate the mounting and/or positioning of the array of electron emission modules attached to the module support member.

In some embodiments, the array of the electron emission modules can be included into an electron emitter device for being positioned and configured for being mounted to a wall of an oven or the top of an oven. The oven can include a conveyance mechanism or transport mechanism configured to support one or more wafers for being soldered and/or undergoing oxide removal and move the one or more wafers through different zones of the oven at a pre-selected speed. In some embodiments, the conveyance mechanism can include rollers, for example, that can be moved to transport wafer(s) through the oven.

In some embodiments, the oven can include a loading zone in which the wafer(s) can be loaded onto the conveyance mechanism for transport through the oven, at least one preheat zone, at least one electron attachment zone, a reflow zone, at least one cooling zone, and an off load zone at which the treated wafers can be output from the oven. The wafer(s) can undergo soldering prior to electron attachment or can be passed through the oven to only have oxides removed. The electron attachment processing can occur via the pulsing of positive and negative voltage (e.g. DC voltage) to the electron emitting members of the modules of the electron emitting device for outputting the electrons to the wafer's outer surface for treating that surface to remove oxides. The atmosphere of the oven can include nitrogen and hydrogen gas as discussed above during the electron attachment processing (e.g. a gas mixture comprising from 95 to 100 vol% nitrogen gas and from 0 to 5 vol% hydrogen gas). After the wafer(s) are output from the oven, the wafer(s) can be included into packaging or otherwise utilized.

In a first aspect, an electron emitter device for an apparatus for oxide removal from solder bumps on a surface of a wafer and/or solder caps on pillars of the surface of a wafer is provided. The electron emitter device can include an electron emission module having a first housing element, an electron emitting member having a base and a plurality of projections extending from the base, and a second housing element releasably attached to the first housing element to form a housing such that the base of the electron emitting member is within a chamber of the housing and the projections extend through spaced apart openings defined in the housing. The housing can be sized and configured for attachment to an electron emission module support member.

Some embodiments can be provided so that multiple electron emission modules can be included on or attached to an electron emission module support member so that there are multiple electron emission modules included on the same electron emission module support member. The electron emission module support member can be shaped and configured to define positions for the different electron emission modules thereon so the different modules can be positioned in a pre-defined arrangement on the electron emission module support member.

In a second aspect, the openings of the housing can be defined at an interface between the first housing element and the second housing element wherein the first housing element abuts the second housing element at the interface. In other embodiments, the openings may be defined in the first housing element and/or the second housing element of the housing.

In a third aspect, the first housing element can have a conductive member and the second housing element can also have a conductive member such that the openings of the housing are positioned between the conductive member of the first housing element and the conductive member of the second housing element. In some embodiments, the conductive member of the first housing element includes a strip of metal or is a strip of metal and the conductive member of the second housing element includes a strip of metal or is a strip of metal.

In a fourth aspect, the electron emitter device can include a plurality of fasteners extending between the first housing element and the second housing element to releasably attach the first housing element to the second housing element to form the housing. For example, bolts and/or screws can be utilized as the fasteners.

In a fifth aspect, the electron emitter device can include the electron emission module support member. The electron emission module support member can have a plurality of wiring openings and the electron emission module support member can also have a plurality of wiring conduits. The first side of the electron emission module support member can face toward the electron emission module. A second side of the electron emission module support member can be opposite its first side.

In a sixth aspect, the electron emitter device can also include an oven mounting member attached to the second side of the electron emission module support member wherein the second side of the electron emission module support member is opposite the first side of the electron emission module support member. The oven mounting member can facilitate mounting of the electron emitter device to an oven or furnace (e.g. a wall or ceiling of the oven within a chamber of the oven, etc.). In some embodiments, the oven mounting member can include a plate or other type of mounting member, for example.

In a seventh aspect, the electron emitting member is comprised of metal or an electrically conductive material and the projections are integrated with the base such that the electron emitting member is a unitary body. For example, the electron emitting member can be formed from a body of metal on which the projections are formed via machining of the metal.

In an eighth aspect, the electron emitter device can include multiple electron emission modules. For instance, the electron emission module of the first aspect can be considered a first electron emissions module and the electron emitter device can also include a second electron emission module. The second electron emission module can have a structure similar to the first electron emission module. For instance, the second electron emission module can have a first housing element of the second electron emission module; an electron emitting member of the second electron emission module wherein the electron emitting member of the second electron emission module has a base and a plurality of projections extending from the base, and a second housing element of the second electron emission module that is releasably attached to the first housing element of the second electron emission module to form a housing of the second electron emission module such that the base of the electron emitting member of the second electron emission module is within a chamber of the housing of the second electron emission module and the projections of the electron emitting member of the second electron emission module extend through openings defined in the housing of the second electron emission module. The housing of the second electron emission module can be sized and configured for attachment to the electron emission module support member.

In some embodiments, the electron emitter device can also include a third electron emission module. The third electron emission module can be structured similarly to the first and second electron emission modules. For example, the third electron emission module can have a first housing element of the third electron emission module, an electron emitting member of the third electron emission module wherein the electron emitting member of the third electron emission module has a base and a plurality of projections extending from the base, and a second housing element of the third electron emission module releasably attached to the first housing element of the third electron emission module to form a housing of the third electron emission module such that the base of the electron emitting member of the third electron emission module is within a chamber of the housing of the third electron emission module and the projections of the electron emitting member of the third electron emission module extend through openings defined in the housing of the third electron emission module. The housing of the third electron emission module can be sized and configured for attachment to the electron emission module support member.

In some embodiments, the electron emitter device can also include at least one fourth electron emission module. Each fourth electron emission module can be structured similarly to the first, second, and third electron emission modules. For example, each fourth electron emission module can have a first housing element of the fourth electron emission module, an electron emitting member of the fourth electron emission module wherein the electron emitting member of the fourth electron emission module has a base and a plurality of projections extending from the base, and a second housing element of the fourth electron emission module releasably attached to the first housing element of the fourth electron emission module to form a housing of the fourth electron emission module such that the base of the electron emitting member of the fourth electron emission module is within a chamber of the housing of the fourth electron emission module and the projections of the electron emitting member of the fourth electron emission module extend through openings defined in the housing of the fourth electron emission module. The housing of the fourth electron emission module can be sized and configured for attachment to the electron emission module support member.

In some embodiments, the electron emitter device can include the electron emission module support member, which can have a plurality of wiring openings and a plurality of wiring conduits. A first side of the electron emission module support member can face toward at least one of the first, second, third, and/or fourth electron emission modules. The first electron emission module can be positioned adjacent to or on a respective set of the wiring openings and at least one of the wiring conduits, the second electron emission module can be positioned adjacent to or on a respective set of the wiring openings and at least one of the wiring conduits, the third electron emission module can be positioned adjacent to or on a respective set of the wiring openings and at least one of the wiring conduits, and/or the fourth electron emission module can be positioned adjacent to or on a respective set of the wiring openings and at least one of the wiring conduits.

In a ninth aspect, the electron emitter device of the first aspect can include one or more features of the second aspect, third aspect, fourth aspect, fifth aspect, sixth aspect, seventh aspect, and/or eighth aspect. Embodiments can also include other elements or features. Examples of other elements or features can be appreciated from the exemplary embodiments discussed herein.

In a tenth aspect, a process for removal of surface oxides from at least one wafer is provided. Embodiments of the process can include providing an electron emitter device for positioning in an electron attachment zone of an oven. The electron emitter device can be an embodiment of the electron emitter device of the first aspect, second aspect, third aspect, fourth aspect, fifth aspect, sixth aspect, seventh aspect, eighth aspect or ninth aspect discussed above. For example, the electron emitter device can include an electron emission module having a first housing element; an electron emitting member having a base and a plurality of projections extending from the base, and a second housing element releasably attached to the first housing element to form a housing such that the base of the electron emitting member is within a chamber of the housing and the projections extend through openings defined in the housing. The housing can be sized and configured for attachment to an electron emission module support member.

The process can also include positioning the electron emitter device in the electron attachment zone of an oven or furnace for emitting electrons to remove oxides from at least one surface of at least one wafer passed through the oven. Embodiments of the process can also include other steps or features.

In an eleventh aspect, the process of the tenth aspect can further include positioning the electron emitting member in a chamber of the first housing element and forming the first electron emission module by attaching the second housing element to the first housing element so that the electron emitting member is within the formed housing between the first housing element and the second housing element and the projections of the electron emitting member extend through the openings. In some embodiments, the openings can be defined at an interface between the first housing element and the second housing element at which the first housing element abuts the second housing element. In other embodiments the openings can be defined in the first housing element or the second housing element. In yet other embodiments, some of the openings can be defined in the first housing element and some of the openings can be defined in the second housing element.

In some embodiments, the openings of the housing and the projections can be positioned between a conductive member of the first housing element and a conductive member of the second housing element. Each conductive member can be a strip of metal or a strip of another type of conductive material.

In a twelfth aspect, the process can also include removing the electron emission module from the electron emission module support member and replacing the removed electron emission module with a new electron emission module.

In a thirteenth aspect, the process can include removing the electron emission module from the electron emission module support member and separating the first housing element from the second housing element to replace the electron emitting member with a new electron emitting member. The process can also include positioning the new electron emitting member between the first housing element and the second housing element and releasably attaching the first housing element to the second housing element via fasteners to form the housing so that a base of the new electron emitting member is enclosed within the first housing element and the second housing element and projections that extend from the base of the new electron emitting member extend through the openings of the housing.

As discussed above, in some embodiments, the openings of the housing through which the projections of the new electron emitting member extend can be defined at an interface between the first housing element and the second housing element at which the first housing element abuts the second housing element. In other embodiments, at least some of the openings may be defined at the interface, defined in the first housing element, and/or defined in the second housing element.

In a fourteenth aspect, the process can include positioning the electron emission module on the electron emission module support member so that the electron emission module is positioned adjacent to at least one of a plurality of wiring openings defined in the electron emission module support member and at least one of a plurality of wiring conduits defined in the electron emission module support member.

In some embodiments, the electron emission module can be a first electron emission module and providing the electron emitter device can also include positioning additional electron emission modules on the electron emission module support member. For example, the process can also include positioning a second electron emission module on the electron emission module support member so that the second electron emission module is spaced apart from the first electron emission module and the second electron emission module is positioned adjacent to at least one of the plurality of wiring openings defined in the electron emission module support member and at least one of the plurality of wiring conduits defined in the electron emission module support member. As another example, the process can also include positioning a third electron emission module on the electron emission module support member so that the third electron emission module is spaced apart from the first electron emission module and/or spaced apart from the second electron emission module and the third electron emission module is positioned adjacent to at least one of the plurality of wiring openings defined in the electron emission module support member and at least one of the plurality of wiring conduits defined in the electron emission module support member. As yet another example, the process can also include positioning a fourth electron emission module on the electron emission module support member so that the fourth electron emission module is spaced apart from the first electron emission module, the second electron emission module, and/or the third electron emission module, and the fourth electron emission module is positioned adjacent to at least one of the plurality of wiring openings defined in the electron emission module support member and at least one of the plurality of wiring conduits defined in the electron emission module support member.

In a fifteenth aspect, the process of the tenth aspect can include one or more features of the eleventh aspect, twelfth aspect, thirteenth aspect, and/or fourteenth aspect. Embodiments can also include other elements or features. Examples of other elements or features can be appreciated from the exemplary embodiments discussed herein.

In a sixteenth aspect, a system for oxide removal from solder bumps on a surface of a wafer and/or solder caps on pillars of the surface of the wafer is provided. The system can include an oven having at least one electron attachment zone and an electron emission module positioned in the electron attachment zone of the oven. The electron emission module can have a first housing element, an electron emitting member having a base and a plurality of projections extending from the base, and a second housing element releasably attached to the first housing element to form a housing such that the base of the electron emitting member is within a chamber of the housing and the projections extend through openings defined in the housing. The housing can be attached to an electron emission module support member. The electron emission module support member can be attachable to a wall or a ceiling of the oven so electrons are emittable from the projections to be directed to the surface of the wafer positioned on a conveyance mechanism of the oven.

In some embodiments, the electron emission module can be an electron emission module of an electron emitter device. The electron emitter device can be an embodiment of the electron emitter device of the first aspect, second aspect, third aspect, fourth aspect, fifth aspect, sixth aspect, seventh aspect, eighth aspect or ninth aspect, for example.

Embodiments of the system can also utilize other elements or features. For example, the system can include process control elements, sensors, or other mechanisms or features.

The oven of the system can be considered a furnace in some embodiments. The oven can also include other zones upstream and/or downstream of the electron attachment zone in some embodiments.

It should be appreciated that embodiments of the process for removal of surface oxides, the apparatus for removal of surface oxides, and the electron emitter device can utilize various structural elements and/or process control elements. The embodiments may utilize sensors (e.g., pressure sensors, temperature sensors, flow rate sensors, concentration sensors, etc.), controllers, valves, piping, and/or other process control elements. Some embodiments can utilize an automated process control system and/or a distributed control system (DCS), for example. Various conduit arrangements and process control systems can be utilized to meet a particular set of design criteria.

Other details, objects, and advantages of the apparatus for removal of surface oxides, process for removal of surface oxides, electron emitter device, and methods of making and using the same will become apparent in the following description of certain exemplary embodiments thereof.

### BRIEF DESCRIPTION OF THE DRAWINGS

Exemplary embodiments of a process for removal of surface oxides, an apparatus for removal of surface oxides, an electron emitter device, and methods of making and using the same are shown in the drawings included herewith. It should be understood that like reference characters used in the drawings may identify like components.
Figure 1 (also referred to as FIG. 1) is a schematic illustration of an apparatus 1 for wafer processing that can include an apparatus 4 for the removal of surface oxides that can include multiple electron emitter devices 5.
Figure 2 (also referred to as FIG. 2) is a schematic diagram of an exemplary embodiment of an electron emitter device 5.
Figure 3 (also referred to as FIG. 3) is a schematic diagram of an exemplary embodiment of an electron emitter module of the electron emitter device 5.
Figure 4 (also referred to as FIG. 4) is a top view of the electron emitter module of the electron emitter device 5.
Figure 5 (also referred to as FIG. 5) is a cross-sectional view of electron emitter module of the electron emitter device 5 taken along line E-E in Figure 4.
Figure 6 (also referred to as FIG. 6) is a schematic diagram of an emitter member of the electron emitter module of the electron emitter device 5.
Figure 7 (also referred to as FIG. 7) is a top view of an intermediate support 8 of the electron emitter device 5.
Figure 8 (also referred to as FIG. 8) is a bottom view of an intermediate support 8 of the electron emitter device 5.
Figure 9 (also referred to as FIG. 9) is a bottom view of a mounting support 7 of the electron emitter device 5.
Figure 10 (also referred to as FIG. 10) is a flow chart illustrating a process for the removal of surface oxides. Embodiments of the apparatus 1 for the removal of surface oxides and/or at least one electron emitter device 5 can be utilized in embodiments of the process.

Reference numerals utilized in the drawings include:
- 1: apparatus for wafer processing;
- 3: oven;
- 4: apparatus for the removal of surface oxides;
- 5: electron emitter device;
- 5a: first electron emitter device;
- 5b: second electron emitter device;
- 6: conveyance mechanism;
- 7: oven mounting member;
- 7a: mounting structure facing side of oven mounting member;
- 8: electron emission module mounting member;
- 8a: first side of electron emission module mounting member;
- 8b: second side of electron emission module mounting member;
- 8c: wiring conduit;
- 8o: wiring opening;
- 9: electron emission module;
- 10: housing;
- 10a: first housing element;
- 10b: second housing element;
- 10f: fastener;
- 10i: interface;
- 10m: conductive member of housing element;
- 10o: opening;
- 11: electron emitting member;
- 11b: base of electron emitting member;
- 11p: projection of electron emitting member;
- S1: first step;
- S2: second step;
- S3: third step;
- S4: fourth step;
- S5: fifth step;
- W: wafer; and
- WM: wafer movement direction.

### DETAILED DESCRIPTION OF THE INVENTION

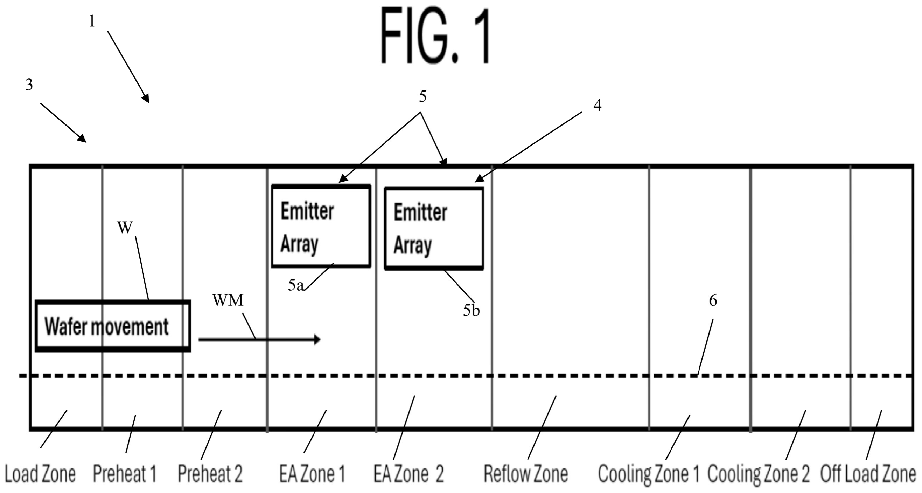

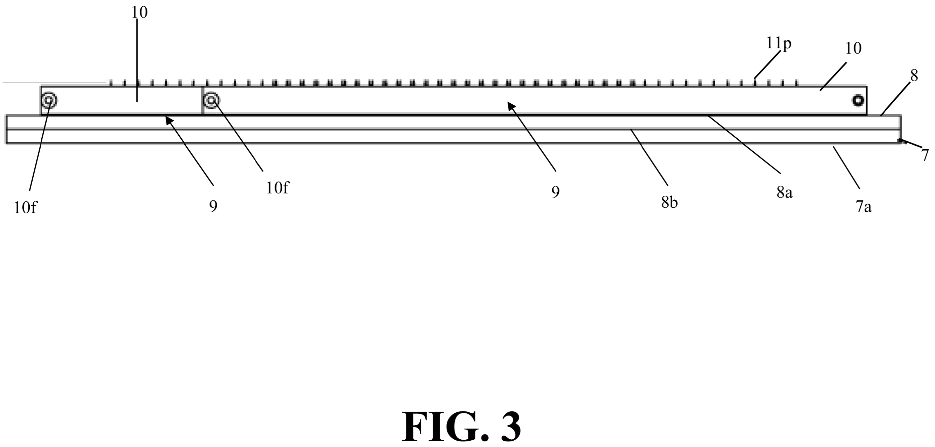

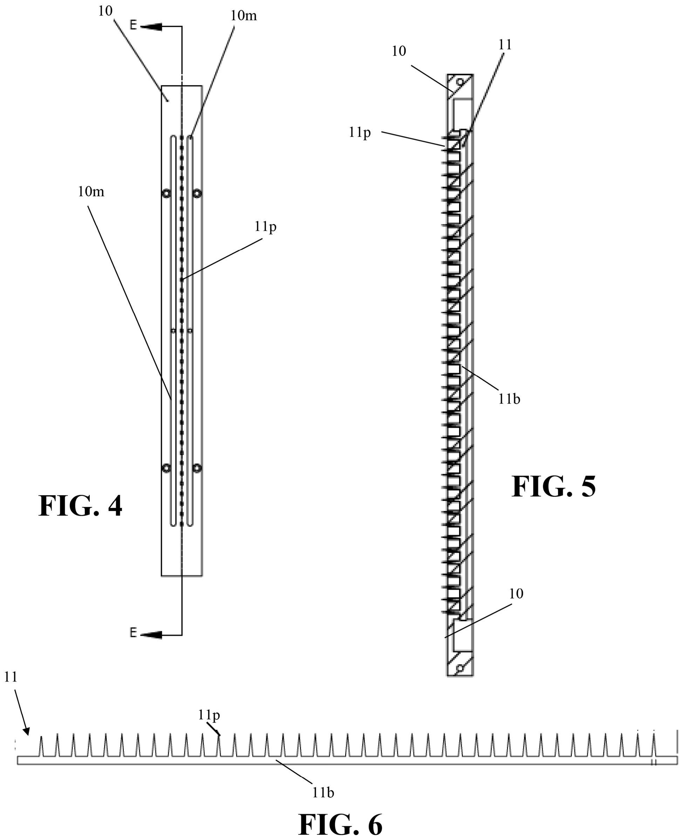

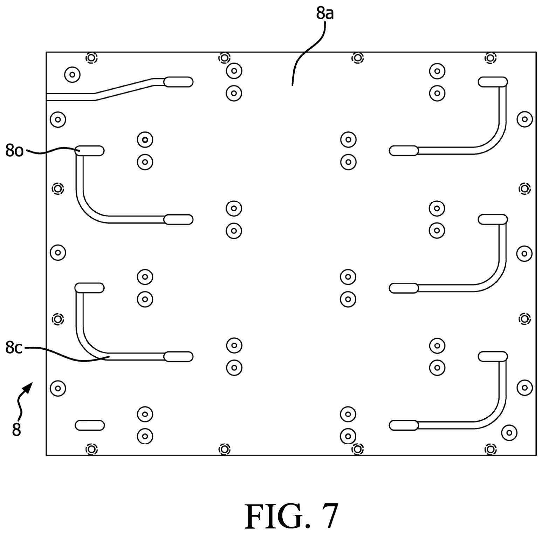

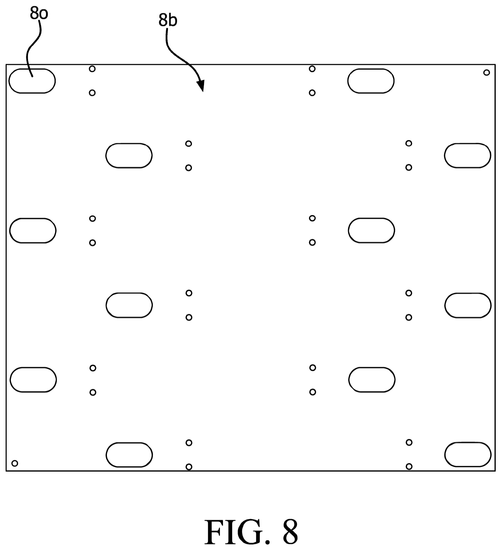

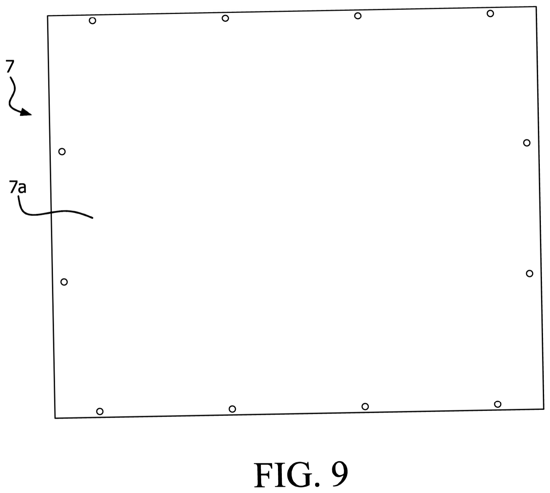

Referring to Figures 1-10, an apparatus 1 for wafer processing can include an oven 3 that can include a housing for enclosing an atmosphere around one or more zones of the oven 3. The oven 3 can also be considered a furnace. The zones of the oven 3 can include a first zone, which can be considered a "Load Zone" or a loading zone in which one or more wafers W can be positioned on a conveyance mechanism 6 for being moved through the oven 3 in a wafer movement direction WM. The zones of the oven can also include at least one preheating zone, at least one electron attachment (EA) zone, at least one reflow zone, at least one cooling zone, and at least one off loading zone, or "Off Load Zone", in which the wafer(s) W can be removed from the conveyance mechanism for further processing, manipulation, or use.

The wafer(s) W can be silicon wafers or another type of wafer. The wafer(s) can be a silicon wafer on which one or more integrated circuits have been built. In some embodiments, the wafer(s) can be a type of electronic device or can be configured for electronic device packaging.

The one or more preheating zones of the oven can include a first preheating zone (Preheat 1) and a second preheating zone (Preheat 2). The EA zones can include a first EA zone (EA Zone 1) and a second EA zone (EA Zone 2). The one or more cooling zones can include a first cooling zone (Cooling Zone 1) and a second cooling zone (Cooling Zone 2). The zones can be positioned within the oven so that the first preheating zone is between the second preheating zone and the loading zone. The first EA zone can be between the second EA zone and the second preheating zone. The reflow zone can be between the first cooling zone and the second EA zone and the second cooling zone can be between the first cooling zone and the off-loading zone.

The oven can be positioned and configured to receive a feed of oven gas for providing an atmosphere within the oven. The oven gas can be a mixture of nitrogen gas and hydrogen gas in some embodiments. For example, hydrogen gas can be present below a concentration at which the hydrogen gas may be flammable and the nitrogen gas can be the remainder of the mixture of the oven gas. In some embodiments, the oven gas can comprise from 95 to 100 vol% nitrogen and from 0 to 5 vol% hydrogen.

The conveyance mechanism 6 that can be positioned in the oven can include conveyor rollers, for transporting the wafer(s) W through the oven 3.

The oven can be configured so that the wafers are preheated to a desired pre-selected electron attachment temperature in the one or more preheating zones, subsequently passed through one or more EA attachment zones for having electrons emitted to the outer surfaces of the wafer(s) W to remove oxides from those surfaces, then passed through a reflow zone before being passed through the cooling zone(s) and finally an off loading zone of the oven. The cooling zones can be zones of the oven at which the temperature of the oven is lower or at ambient temperature to help cool the wafer(s) after they wafer(s) pass through the reflow zone.

The pre-selected electron attachment temperature can be less than the melting point of the solder alloy of the solder bump or the solder cap on the pillars. For example, the pre-selected electron attachment temperature can be in a range of from 100°C to 320°C, from 115°C to 300°C, or from 180°C to 250°C. The preheating zones can be at a temperature to heat the wafer(s) at a pre-selected ramping temperature rate to the pre-selected electron attachment temperature for a pre-selected conveyance speed at which the wafer(s) are transported through the oven via the conveyance mechanism. The pre-selected ramping temperature can be determined based on the melting point of the solder alloy for the solder bump and solder caps on the pillars (e.g. copper pillars, etc.). In some embodiments, the pre-selected ramping temperature rate can be between 40°C per hour and 60°C per hour. Other embodiments may utilize other ramping temperature rates.

Each EA attachment zone can include at least one electron emitter device 5 that includes an emitter array. The emitter array of each electron emitter device can include one or more electron emission modules 9. For instance, the first EA attachment zone can include at least one first electron emitter device 5a mounted to a wall or ceiling of the oven for directing electrons to the outer surfaces of the wafer(s) below the electron emitter device(s) 5 via at least one electron emitting member 11 of one or more electron emission modules 9 of the device. The second EA attachment zone can also include at least one second electron emitter device 5b mounted to a wall or ceiling of the oven for directing electrons to the outer surfaces of the wafer(s) below the electron emitter device(s) 5 via at least one electron emitting member 11 of one or more electron emission modules 9 of the device.

The electron emitter device(s) 5 can be positioned in the oven to emit electrons toward the surface(s) of the wafer(s) to remove oxides from the wafer surface(s) and/or bumps formed on the wafer surface(s) via soldering. Each electron emitter device 5 can be electrically coupled to a source of positive and negative direct current voltage for having that voltage pulsed to electron emission modules 9 of the electron emitter device 5 so electrons can be directed to the outer surface(s) of the wafer(s) passing under the electron emitter device 5 or passing by the electron emitter device 5 so that hydrogen can dissociate and add an electron to form hydrogen anions within the atmosphere of the oven and react with oxides on the solder bumps and solder caps on the pillars on the surface(s) of the wafer(s) W to remove the oxides from the wafer surface(s). The voltage fed to the electron emission modules 9 of the electron emitter device 5 can be pulsed so that the electrons can be directed to the outer surface for facilitating a reaction between the hydrogen gas and the oxides to form water vapor and remove the oxides from the surface(s) of the wafer(s). Also, the pulsing can be performed to remove excess electrons from the wafer(s) W to avoid a buildup of charge in the wafer(s) W.

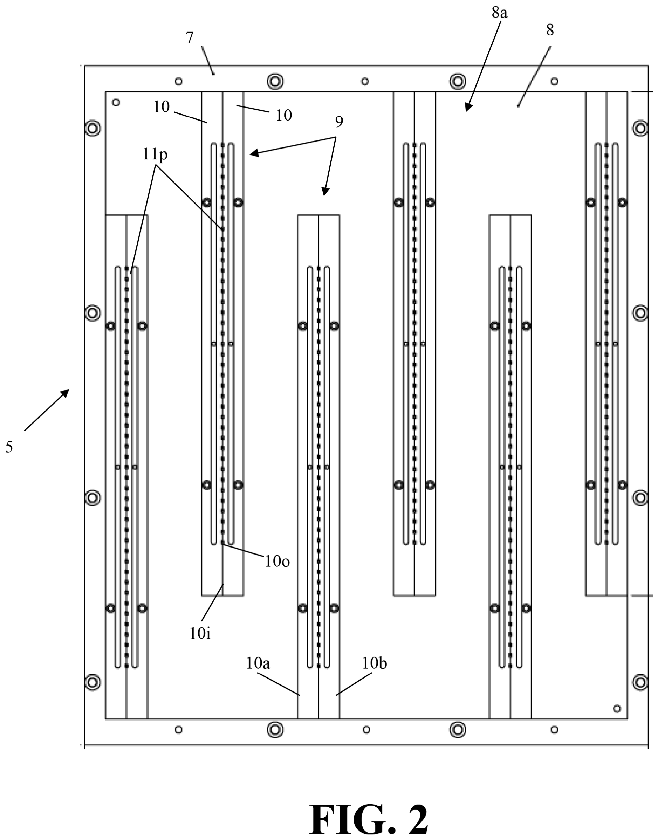

As may best be appreciated from Figures 2-9, each of the electron emitter devices 5 can include a plurality of electron emission modules 9 that can be connected to an electron emission module support member 8. In some embodiments, the electron emission module support member 8 can be connected to an oven mounting member 7 so that the electron emission module support member 8 is positioned between the oven mounting member 7 and the electron emission modules 9. The oven mounting member 7 can have a mounting structure facing side 7a that can be configured to facilitate mounting of the electron emitter device 5 to a wall or ceiling of the oven 3. Fasteners and/or other attachment mechanisms can be utilized to attach the oven mounting member 7 to the oven ceiling or oven wall. Fasteners and/or other attachment mechanisms can be utilized to attach the oven mounting member to the electron emission module support member 8. Fasteners and/or other attachment mechanism can also be utilized to attach the electron emission modules 9 to the electron emission module support member 8.

Each electron emission module 9 can have an electron emitting member 11 positioned between different housing elements (e.g. first and second housing elements 10a, 10b, etc.) to enclose a majority of the electron emitting member 11 within a formed housing 10 of the electron emission module 9. The electron housing elements can include at least two housing elements such as the first housing element 10a and a second housing element 10b. Each housing element 10a can define a chamber and have openings defined therein so that when the first and second housing elements 10a, 10b are attached together, they define openings 10o in the formed housing at an outer surface of the housing adjacent an interface 10i between the first and second housing elements 10a, 10b. The first and second housing elements 10, 10b can be fastened together via fasteners after the electron emitting member 11 is positioned between those housing elements so that projections 11p can extend out of the openings 10o of the housing so that the base 11b of the electron emitting member 11 is in a chamber of the formed housing 10 in communication with the openings 10o through which projections 11p of the electron emitting member extend.

Distal tips of the projections 11p can be positioned away from the housing 10 outside of the outer surface of the housing 10 via the projections 11p extending through and out of the openings 10o.

Each of the first and second housing elements 10a, 10b can have a chamber that can partially define the chamber of the housing that retains the base 11b of the electron emitting member 11. For assembly of each electron emission module, the electron emitting member 11 can be positioned in a chamber of the first housing element 10a so that projections 11p extend out of portions of the openings 10o defined by that first housing element 10a. The second housing element 10b can be positioned next to the first housing element to form the openings 10o at the interface 10i between the first and second housing elements 10a, 10b to enclose the base of the electron emitting member 11 in the chamber of the formed housing 10. Fasteners can then be passed through the first and second housing elements to attach those elements together to complete the housing 10 with the distal ends of the projections 11p positioned outside of the chamber and openings 10o.

Each housing element can also have a conductive member 10m positioned to extend adjacent to the openings 10o so that the openings 10o are between the interface 10i and the strip of conductive material. Each conductive member 10m can be strip of metal (e.g. a strip of copper, a strip of aluminum, etc.) or another type of elongated member composed of an electrically conductive material.

Each housing element can include a lower opening for receipt of wiring or a connector of wiring to receive the transmission of voltage and/or current to the electron emitting member 11. The lower opening can be on a side of the housing element that is opposite the side having the portion of the openings 10o through which the projections 11p are to extend. The lower openings of the housing elements can be defined to mate with lower openings of other housing elements so that the formed housing 10 can have wire connection receiving apertures defined therein that can face toward the electron emission module support member 8 and be aligned with respective wire connection openings 8o defined in the electron emission module support member 8.

The electron emission module support member 8 can be a metallic member or a member comprised of another type of material (e.g. polymeric material, etc.) that can have openings 8o defined there to receive wiring. The first side of the electron emission module support member 8 can be configured to face toward the electron emission modules 9 and can include wiring conduits 8c defined therein to extend between different openings 8o defined in the electron emission module support member 8. The wiring conduits 8c can be grooves that are defined in the first side 8a of the electron emission module support member 8 to extend between different openings 8o to facilitate the routing of wiring for connecting the wiring to different electron emitting members 11 of the different electron emission modules 9.

In some embodiments, the wiring conduits 8c can be curved or elbow shaped grooves defined between adjacent openings 8o, for example. The openings 8o and wiring conduits 8c can be defined on the first side of the electron emission module support member 8 to facilitate the positioning of wiring and/or routing of wiring along the electron emission module support member 8 for electrically coupling the electron emitting members 11 within different housings 10 of different electron emission modules to the source of voltage that can be pulsed to emit electrons.

The electron emission module support member 8 can have a second side 8b opposite its first side that can face toward the oven mounting member 7. This second side may have openings 8o that can pass through the first and second sides 8a, 8b of the electron emission module support member 8, but may not have any wiring conduits 8c defined thereon. In yet other embodiments, it is contemplated that wiring conduits 8c can also be defined on the second side 8b of the electron emission module support member 8.

Fastener holes can also be defined in the electron emission module support member 8 adjacent to openings 8o to facilitate positioning and fastening of the housing elements 10a of each of the electron emission modules 9 to the first side 8a of the electron emission module support member 8. The openings 8o and wiring channels 8c can be defined on the first side 8a of the electron emission module support member 8 to facilitate positioning of the housings 10 of the electron emission modules 9 and attachment of those electron emission module housings 10 to the first side 8a of the electron emission module support member 8.

In some embodiments, fasteners for mounting of the housings 10 of the electron emission modules 9 to the electron emission module support member 8 can pass through the electron emission module support member 8 and also engage or contact the oven mounting member 7. In other configurations, the fasteners may extend from the second side 8b of the electron emission module support member 8 to the lower portion of the housing elements 10a, 10b of each housing 10 for attachment of the housings 10 of the electron emission modules 9 to the electron emission module support member 8.

The electron emitting member 11 can be an integral structure. For example, the electron emitting member 11 can be formed from metal and can be drilled or cut to form the projections 11p so that the base 11b is integral with the projections 11p, the distal ends of the projections have a pre-selected thickness or pre-selected profile, and the entirety of the electron emitting member 11 is a unitary structure. In some embodiments, the electron emitting member 11 can be composed of stainless steel, aluminum, copper, or other type of metal or alloy. In yet other embodiments, the electron emitting member can be formed from another type of conductive material.

In some embodiments, each of the projections 11p can be defined to have multiple emitting surfaces due to the angles of the distal end of the projection 11p (e.g. emitter projection tip). In other embodiments, each projection may have a single emitting surface.

The utilization of fasteners and use of the electron emission module support member 8 and/or oven mounting member 7 can help facilitate easy mounting of electron emissions modules 9 for use. Additionally, the housing elements for the housing 10 can include interlocking profiles, mating profiles and/or one or more other attachment mechanisms to help facilitate positioning and attachment of the housing elements for forming the housing 10 and enclosing the base 11b of the electron emitting member 11 so the projections 11p extend through the openings 10o formed at the interface 10i of the housing elements of the housing 10. Examples of such mating or interlocking profiles can include corresponding tongue and groove profiles, corresponding dovetail joint profiles, or other types of mating profiles or interlocking profiles.

In yet other embodiments, the openings 10o can be defined in one of the housing elements instead of at the interface 10i of the housing elements. In such an embodiment, the openings 10o may be defined to help locate the electron emitting member 11 for forming of the housing 10 and positioning of the electron emitting member 11 in a desired location for the forming of the housing 10 to enclose the base 11b of the electron emitting member 11 within the housing 10 while the projections 11p extend through the openings 10o.

Embodiments can also be configured to allow for quicker and more efficient repair or maintenance work to occur. For instance, in the event that certain projections 11p of the electron emitting member 11 become damaged or stop working effectively, a module 9 can be easily accessed, removed from the electron emission module support member 8, and replaced with a new electron emission module 9. Also (or alternatively), the housings 10 can be structured so that removal of fasteners 10f can permit the electron emitting member 11 to be removed and a new electron emitting member 11 to be positioned to replace the damaged electron emitting member 11. Then, the housing elements can be fastened back together, and the repaired module can be mounted back onto the electron emission module support member 8 via use of the fasteners. This type of functionality and module arrangement can permit an array of modules to be more easily repaired and/or maintained while also making it easier and simpler to fabricate an electron emitter device 5. Embodiments can permit repair work to occur much more quickly and allow for inventory for maintenance purposes to be obtained and stored on-hand in a less costly and more easily utilizable fashion. This can help greatly reduce the downtime associated with maintenance and repair work and also help provide enhanced operational flexibility.

Embodiments of the electron emitter device(s) 5 and the electron emission modules 9 can be utilized in embodiments of processes for removal of surface oxides. Embodiments of such a process can also include an embodiment of providing an electron emitter device 5 and/or repair and replacing of at least one electron emission module 9 of an electron emitter device 5.

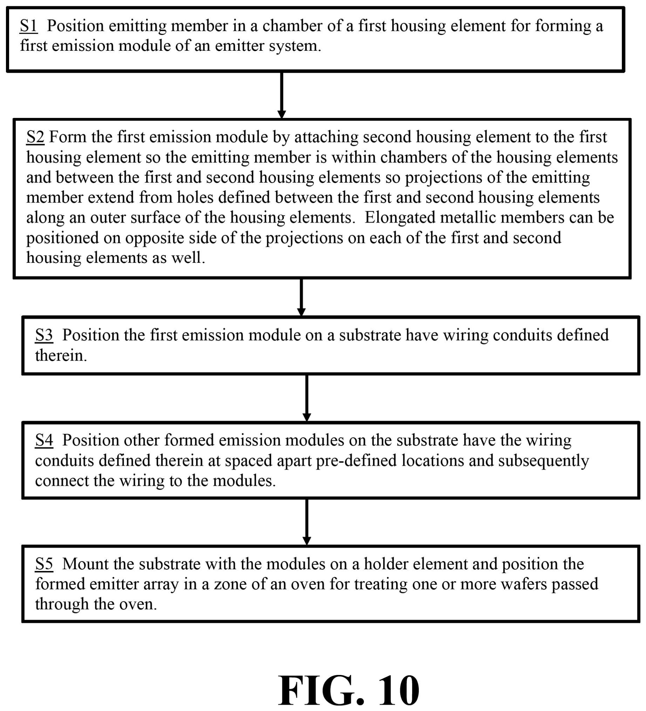

An example of an embodiment of a process can be seen in Figure 10. For example, in a first step S1, an emitting member 11 can be positioned in a chamber of a first housing element 10a for forming a first electron emissions module 9 of an electron emitter device 5. In a second step S2, the first electron emission module 9 can then be formed by attaching a second housing element 10b to the first housing element 10a so that the base 11b of the electron emitting member 11 is positioned within the chambers of the housing elements 10a, 10b and between the first and second housing elements 10a, 10b so projections 11p of the electron emitting member 11 can extend from openings 10o (e.g. holes, etc.) defined between the first and second housing elements 10a, 10b. These openings 10o can be defined at an interface 10i at which the first housing element 10a abuts the second housing element 10b, for example.

In some embodiments, elongated conductive members 10m can be positioned on the first and second housing elements 10a, 10b to be positioned adjacent to the openings 10o so that the openings 10o and projections 11p are between the conductive members 10m positioned on the first and second housing elements 10a, 10b that form the housing 10. The conductive members 10m can be positioned on the housing elements 10a, 10b, prior to the housing elements being attached together to form the housing and/or prior to the positioning of the electron emitting member within a chamber of at least one of the housing elements for positioning and attachment of the housing elements for forming the housing 10 and electron emission module 9.

In a third step S3, the first electron emission module 9 can be positioned on a substrate. For example, the formed first electron emission module 9 can be positioned on a first side 8a of the electron emission module support member 8. Wiring conduits 8c and wiring openings 8o of the first side 8a of the electron emission module support member 8 can face toward the first electron emission module 9 and the positioning of the first electron emission module 9 can be guided by the locations of the wiring openings 8o and the wiring conduits 8c (e.g. wiring grooves that may extend between wiring openings 8o).

In a fourth step S4, other formed electron emission modules 9 can be formed in the same way that the first electron emission module 9 was formed, and can be positioned on the first side 8a of the electron emission module support member 8 in a pre-arranged pattern that can be defined by the wiring conduits 8c and wiring openings 8o of the first side 8a of the electron emission module support member 8. Each electron emission module 9 can be positioned so that a respective set of the wiring openings 8o and wiring conduits 8c face toward the electron emission module 9 and these wiring openings 8o and wiring conduits 8c can guide the locations at which the electron emission modules 9 are to be positioned on the first side 8a of the electron emission module support member 8.

Each of the electron emission modules 9 can be fastened to the first side 8a of the electron emission module support member 8 via fasteners (e.g. bolts or screws, etc.) and/or other connection mechanisms (e.g. interlocking profiles, mating profiles, etc.) to facilitate releasable connection of the electron emission modules 9 to the first side 8a of the electron emission module support member 8. Wiring can be coupled to the electron emitting members 11 of the modules 9 via use of the wiring openings 8o and wiring conduits 8c prior to the modules 9 being connected to the first side 8a of the electron emission module support member 8 or after the modules are connected to the first side 8a of the electron emission module support member 8.

In a fifth step S5, the substrate to which the electron emission modules 9 are mounted can be mounted onto a holder element for positioning the electron emitter device 5 in a zone of an oven for treating one or more wafers W passed through the oven for removal of oxides from the surface(s) of the wafer(s) W via electron attachment. Such electron attachment processing can be provided via pulsing voltage applied to the electron emitting members 11 of the electron emission modules 9 of the electron emitter device 5.

For example, the second side 8b of the electron emission module support member 8 can be connected to the oven mounting member 7. The oven mounting member can then be fastened to ceiling or wall mounting structure, a ceiling, or a wall, of the oven for mounting and positioning of the electron emitter device 9 in the oven 3 within an EA zone of the oven. Fasteners and/or other connectors may be utilized to facilitate such connection and mounting.

The mounted electron emitter device 5 may then be used in operations for removal of oxides from the wafer(s) W as discussed above. For example, each electron emitter device 5 can be electrically coupled to a source of positive and negative direct current voltage so that the voltage may be pulsed to electron emitting members 11 of the electron emission modules 9 of the electron emitter device 5 and electrons can be emitted out of the projections 11p and directed to the outer surface(s) of the wafer(s) passing under the electron emitter device 5 or passing by the electron emitter device 5. As a result, hydrogen can be dissociated to form hydrogen anions by attaching to free electrons within the atmosphere of the oven, which can react with oxides on the solder bumps and solder caps of the pillar surface(s) of the wafer(s) W to remove the oxides from the surface(s). The voltage fed to the electron emitting members 11 of the electron emitter device 5 can be pulsed so that the electrons can be directed to the outer surface to facilitate a reaction between the hydrogen anions formed from the gas and the oxides to form water vapor and remove the oxides from the solder bumps and/or solder caps on pillars of the surface(s) of the wafer(s). Also, the pulsing can be performed to remove excess electrons from the wafer(s) W to avoid a buildup of charge in the wafer(s) W.

In the event one or more of the electron emission modules 9 need to be repaired or replaced, such electron emission module(s) 9 can be removed from the first side 8a of the electron emission module support member 8 and be replaced with a new electron emission module 9. Alternatively, the electron emission module 9 can be removed from the first side 8a of the electron emission module support member 8, the housing elements 10a, and 10b can be separated from each other, and the electron emitting member 11 can be replaced with a new electron emitting member 11. Then, the first and second housing elements 10a, 10b can be refastened together so the projections 11p of the new electron emitting member 11 are passed through the openings 10o and the formed electron emission module 9 can be attached to the first side 8a of the electron emission module support member 8 and the new electron emitting member 11 can be wired to the source of voltage for subsequent use.

This type of modular structure can facilitate improved repair and replacement operations so that such work can be performed much more quickly and easily. Also, it can help reduce downtime associated with such maintenance or repair work.

It should also be appreciated that modifications to embodiments of the apparatus 1 and process can also be made to meet particular criteria or specifications of the apparatus or process. For instance, embodiments can be configured to be utilized in conjunction with an automated process control scheme and/or distributed control scheme and the size or type of the equipment can be modified to meet a particular set of design criteria as well. As another example, the number of electron emission modules 9, shapes of the housings 10, and/or shapes of the electron emitting members 11 can be any of a number of suitable sizes and shapes to meet pre-selected design criteria. As another example, the material composition of the different elements can be any of a number of suitable options to meet pre-selected design criteria. As yet another example, the type of wiring, arrangement of wiring openings 8o and wiring conduits 8c, the shape and profile of the housing 10, the electron emission module support member 8, and/or oven mounting member 7 can be any of a number of suitable shapes and sizes to meet design criteria or oven size. It should also be appreciated the oven 3 can be considered a furnace.

A particular feature described herein, either individually or as part of an embodiment, can be combined with other individually described features, or parts of other embodiments. The elements and acts of the various embodiments described herein can therefore be combined to provide further embodiments. Thus, while certain exemplary embodiments of the process, apparatus, system, and methods of making and using the same have been shown and described above, it is to be distinctly understood that the invention is not limited thereto but may be otherwise variously embodied and practiced within the scope of the following claims.

## Claims

1. An electron emitter device for oxide removal, the electron emitter device comprising:
an electron emission module, the electron emission module comprising:
a first housing element;
an electron emitting member comprising a base and a plurality of projections extending from the base; and
a second housing element releasably attached to the first housing element to form a housing such that the base of the electron emitting member is within a chamber of the housing and the plurality of projections extend through openings defined in the housing;
wherein the housing is sized and configured for attachment to an electron emission module support member.

2. The electron emitter device of claim 1, wherein the openings of the housing are defined at an interface between the first housing element and the second housing element, the first housing element abutting the second housing element at the interface, and/or wherein the first housing element comprises a conductive member and the second housing element comprises a conductive member such that the openings of the housing are positioned between the conductive member of the first housing element and the conductive member of the second housing element.

3. The electron emitter device of claim 1 or 2, comprising:
a plurality of fasteners extending between the first housing element and the second housing element to releasably attach the first housing element to the second housing element to form the housing.

4. The electron emitter device of any one of the preceding claims, comprising:
the electron emission module support member, wherein:
the electron emission module support member comprises a plurality of wiring openings and a plurality of wiring conduits, and
a first side of the electron emission module support member faces toward the electron emission module.

5. The electron emitter device of any one of the preceding claims, wherein the electron emitting member is comprised of metal or an electrically conductive material and the plurality of projections are integral with the base such that the electron emitting member is a unitary body.

6. The electron emitter device of any one of the preceding claims, wherein the electron emission module is a first electron emissions module, the electron emitter device also comprising:
a second electron emission module, the second electron emission module comprising:
a first housing element of the second electron emission module;
an electron emitting member of the second electron emission module, the electron emitting member of the second electron emission module comprising a base and a plurality of projections extending from the base; and
a second housing element of the second electron emission module releasably attached to the first housing element of the second electron emission module to form a housing of the second electron emission module such that the base of the electron emitting member of the second electron emission module is within a chamber of the housing of the second electron emission module and the plurality of projections of the electron emitting member of the second electron emission module extend through openings defined in the housing of the second electron emission module;
wherein the housing of the second electron emission module is sized and configured for attachment to the electron emission module support member.

7. A process for removal of surface oxides from at least one wafer, the process comprising:
providing an electron emitter device for positioning in an electron attachment zone of an oven, the electron emitter device comprising:
an electron emission module, the electron emission module comprising:
a first housing element;
an electron emitting member comprising a base and a plurality of projections extending from the base; and
a second housing element releasably attached to the first housing element to form a housing such that the base of the electron emitting member is within a chamber of the housing and the plurality of projections extend through openings defined in the housing;
wherein the housing is sized and configured for attachment to an electron emission module support member; and
positioning the electron emitter device in the electron attachment zone of an oven for emitting electrons for removal of oxides from at least one surface of at least one wafer passed through the oven.

8. The process of claim 7, wherein providing the electron emitter device comprises:
positioning the electron emitting member in a chamber of the first housing element and forming the first electron emission module by attaching the second housing element to the first housing element so that the electron emitting member is within the formed housing between the first housing element and the second housing element and the plurality of projections of the electron emitting member extend through the openings, the openings being defined at an interface between the first housing element and the second housing element at which the first housing element abuts the second housing element.

9. The process of claim 8, wherein the openings of the housing and the plurality of projections are positioned between a conductive member of the first housing element and a conductive member of the second housing element.

10. The process of any one of claims 7 to 9, wherein the at least one surface is a solder bump on the at least one wafer and/or a solder cap on a pillar on the at least one wafer, and/or wherein the process comprises
removing the electron emission module from the electron emission module support member and replacing the removed electron emission module with another electron emission module.

11. The process of any one of claims 7 to 10 , comprising:
removing the electron emission module from the electron emission module support member and separating the first housing element from the second housing element to replace the electron emitting member with a new electron emitting member; and
positioning the new electron emitting member between the first housing element and the second housing element and releasably attaching the first housing element to the second housing element via fasteners to form the housing so that a base of the new electron emitting member is enclosed within the first housing element and the second housing element and plurality of projections that extend from the base of the new electron emitting member extend through the openings of the housing.

12. The process of claim 11, wherein the openings of the housing through which the projections of the new electron emitting member extend are defined at an interface between the first housing element and the second housing element at which the first housing element abuts the second housing element.

13. The process of any one of claims 7 to 12, wherein providing the electron emitter device comprises:
positioning the electron emission module on the electron emission module support member so that the electron emission module is positioned adjacent to at least one of a plurality of wiring openings defined in the electron emission module support member and at least one of a plurality of wiring conduits defined in the electron emission module support member.

14. The process of claim 13, wherein the electron emission module is a first electron emission module and providing the electron emitter device also comprises:
positioning a second electron emission module on the electron emission module support member so that the second electron emission module is spaced apart from the first electron emission module and the second electron emission module is positioned adjacent to at least one of the plurality of wiring openings defined in the electron emission module support member and at least one of the plurality of wiring conduits defined in the electron emission module support member.

15. A system for oxide removal, the system comprising:
an oven comprising at least one electron attachment zone;
an electron emission module positioned in the electron attachment zone of the oven, the electron emission module comprising:
a first housing element;
an electron emitting member comprising a base and a plurality of projections extending from the base; and
a second housing element releasably attached to the first housing element to form a housing such that the base of the electron emitting member is within a chamber of the housing and the plurality of projections extend through openings defined in the housing;
wherein the housing is attached to an electron emission module support member and the electron emission module support member is attachable to a wall or a ceiling of the oven so that electrons emitted from the plurality of projections are directed to the surface of a wafer positioned on a conveyance mechanism of the oven.
